# EUROPEAN PATENT APPLICATION

(11) **EP 4 610 676 A1**
(43) Date of publication of application: **03.09.2025**
(21) Application number: 24160679.7
(22) Date of filing: 29.02.2024
(51) Int. Cl.: G01R 31/12

(54) **SENSOR SYSTEM FOR MEASURING PARTIAL DISCHARGE (PD) IN ELECTRICAL SWITCHGEAR CABINET APPARATUS**

(71) Applicant: Siemens Aktiengesellschaft, 80333 München (DE)
(72) Inventor: G M, Madhu, 577002 Davangarere, Karnataka (IN); RAJEEV, Jose, 682507 Kochi (IN)
(74) Representative: Patentanwaltskanzlei WILHELM & BECK

(57) **Abstract**

A sensor system (200) for measuring partial discharge (PD) in an electrical switchgear cabinet apparatus (1000). The sensor system (200) includes a High Frequency Current Transformer (HFCT) sensor (202) configured to measure a High Frequency Current (HFC) signal and a reconfigurable electronic circuit connected to the HFCT sensor (202) and configured to transform the measured HFC signal indicating the partial discharge activity to a configurable output signal. The sensor system (200) includes output ports connected to the reconfigurable electronic circuit and configured to provide the configurable output signal to an IM unit, a magnitude of the configurable output signal is provided to the instrumentation and measurement (IM) unit. The reconfigurable electronic circuit includes multiple switches, a transient voltage protection diode (D1), multiple termination resistance (R1 and R2) and a passive bandpass filter and the HFC signal is transformed using multiple modes of operation of the reconfigurable electronic circuit.

## Description

The present disclosure relates generally to sensing of partial discharge, and more specifically to a sensor system for measuring partial discharge (PD) in an electrical switchgear cabinet apparatus.

Switchgears must be insulated from its surroundings because the switchgears are used under very high voltages. It is configured to provide shielding to the interconnected devices by controlling, metering and regulating flow of electricity in a distribution management system.

Partial discharge (PD) occurs in an insulation system by localised electrical breakdown of electric insulation materials under high voltage stress. The factors causing the PD include for example but not limited to ageing, improper installation, manufacturing defects, or any other physical damage. In the PD scenario, few milliamperes of high frequency pulsating current discharges are emitted from a deteriorated area of the insulation when applied voltage is greater than breakdown voltage of the deteriorated area of the insulation. This PD leads to permanent insulation damage if untreated resulting in entire equipment failure.

Conventionally, various types of sensors are used to measure PD activity such as for example a high frequency current transformer HFCT). The conventional HFCTs mainly comprises a fixed type of output (such as for example a Bayonet Neill-Concelman or BNC cable) with fixed termination resistance (for example 50 Q) converting PD current pulse to equivalent voltage which is connected to an instrumentation and measurement (IM) unit. Further, the HFCTs are connected in medium voltage (MV) switchgears. However, there is a possibility of magnetic interference which could corrupt the PD measurement signal and hence shielding of the HFCTs to mitigate it is very crucial.

Further, it may be noted that each vendor's IM unit includes different specifications and input requirements. Generally, same vendor's HFCTs are compatible with specific IM units which require specific termination and/or filtered output and/or current as an input and/or have transient voltage protection. Also, the HFCT and the IM units are supplied as a solution and the same HFCT may not be compatible for different IM units. There is no generalized HFCT which can be configured as per the IM unit requirements for PD measurement.

In some other conventional methods and systems, the HFCTs and the IM units are being provided as a single solution for PD measurement by the vendor, when the IM unit is designed to be compatible for the HFCT provided. When a scenario arises of replacing either the HFCT or the IM unit, customer needs to use the same vendor's offering, restricting the use of different HFCTs.

Therefore, there exists a need for the generalized HFCT which can be configured as per the IM unit requirements for measurement of the PD.

The present disclosure seeks to overcome the above-mentioned challenges by using a sensor system which includes a generalized HFCT which can be configured as per the IM unit requirements for measurement of the PD. Therefore, the proposed approach eliminates the requirement of coming up with an IM unit which is designed to be compatible for the specific HFCT as the proposed HFCT is generalized and universal in nature. As a result, the proposed solution is cost-effective and enhances the efficiency of the PD measuring system by enhanced portability between the IMs.

The object of the present disclosure is achieved by a sensor system for measuring partial discharge (PD) in an electrical switchgear cabinet apparatus. The sensor system includes a High Frequency Current Transformer (HFCT) sensor configured to measure a High Frequency Current (HFC) signal and a reconfigurable electronic circuit connected to the HFCT sensor and configured to transform the measured HFC signal indicating the partial discharge activity to a configurable output signal. The sensor system includes output ports connected to the reconfigurable electronic circuit and configured to provide the configurable output signal to an IM unit, a magnitude of the configurable output signal is provided to the instrumentation and measurement (IM) unit. The reconfigurable electronic circuit includes multiple switches, a transient voltage protection diode (D1), multiple termination resistance (R1 and R2) and a passive bandpass filter and the HFC signal is transformed using multiple modes of operation of the reconfigurable electronic circuit.

In one or more embodiments, the output ports are an output connector type comprising one of a SMA type and a BNC type.

In one or more embodiments, the plurality of modes of operation includes:
a. a first mode of operation comprising a first termination resistance, the configurable output signal is the voltage signal and voltage as output and the output connector type is SMA;
b. a second mode of operation comprising the first termination resistance, the configurable output signal is the voltage signal and voltage as output and the output connector type is BNC;
c. a third mode of operation comprising a second termination resistance, the configurable output signal is the voltage signal and voltage as output and the output connector type is SMA;
d. a fourth mode of operation comprising the second termination resistance, the configurable output signal is the voltage signal and voltage as output and the output connector type is BNC;
e. a fifth mode of operation comprising transient voltage protection, the first termination resistance, the configurable output signal is the voltage signal with bandpass filtering and the output connector type is SMA;
f. a sixth mode of operation comprising transient voltage protection, the first termination resistance, the configurable output signal is the voltage signal with bandpass filtering and the output connector type is BNC;
g. a seventh mode of operation comprising transient voltage protection, the second termination resistance, the configurable output signal is the voltage signal with bandpass filtering and the output connector type is SMA;
h. an eighth mode of operation comprising transient voltage protection, the second termination resistance, the configurable output signal is the voltage signal with bandpass filtering and the output connector type is BNC;
i. a ninth mode of operation comprising no termination resistance, the configurable output signal is the current signal, and the output connector type is SMA; and
j. a tenth mode of operation comprising no termination resistance, the configurable output signal is the current signal, and the output connector type is BNC.

In one or more embodiments, the passive bandpass filter is configured to allow a specific frequency range of the HFCT signal for monitoring the PD and wherein the passive bandpass filter is operated using the J7, the J8 and the J9.

In one or more embodiments, the HFCT sensor comprises a primary coil, a secondary coil, and a core of high relative permeability.

In one or more embodiments, the primary coil, the secondary coil, and the core is shielded with aluminium casing to eliminate environmental interferences and noise interferences to the HFCT signal.

In one or more embodiments, the transient voltage protection diode is connected in parallel to the secondary coil of the HFCT sensor and the transient voltage protection diode is operated using the J1 and the J2.

In one or more embodiments, the plurality of termination resistance termination resistance is operated using a combination of: the J3 and the J4, or the J5 and the J6.

In one or more embodiments, further includes an instrumentation and measurement (IM) unit connected to the output ports of the sensor system output type and configured to: receive the configurable output signal through a compatible output connector type and display information associated with the partial discharge activity.

The object of the present disclosure is further achieved by an electrical switchgear cabinet apparatus for measuring partial discharge (PD). The electrical switchgear cabinet apparatus includes the electrical switchgear cabinet comprising a sensor system for measuring the PD. The sensor system includes a High Frequency Current Transformer (HFCT) sensor for determining a HFC signal. The HFC signal is a measure of a partial discharge activity in the electrical switchgear cabinet apparatus. The sensor system also includes a reconfigurable electronic circuit connected to the HFCT sensor for measuring the partial discharge activity based on the HFC signal in a plurality of modes of operation of the sensor system and output ports for providing configurable output signal based on the partial discharge activity, wherein the configurable output signal is one of: a current signal and a voltage signal. The reconfigurable electronic circuit comprises a plurality of switches (J1, J2, J3, J4, J5, J6, J7, J8, J9, J10 and J11), a transient voltage protection diode (D1), a plurality of termination resistance (R1 and R2) and a passive bandpass filter.

The object of the present disclosure is further achieved by a method for measuring partial discharge (PD) in an electrical switchgear cabinet apparatus. The method includes mounting a sensor system within the electrical switchgear cabinet apparatus, wherein the sensor system comprises a HCFT sensor for measuring of a partial discharge activity. The method also includes monitoring the partial discharge activity based on configurable output signal, wherein the configurable output signal is one of: a current signal and a voltage signal and displaying information associated with the partial discharge activity based on the monitoring.

Still other aspects, features, and advantages of the disclosure are readily apparent from the following detailed description, simply by illustrating a number of particular embodiments and implementations, including the best mode contemplated for carrying out the disclosure. The disclosure is also capable of other and different embodiments, and its several details may be modified in various obvious respects, all without departing from the scope of the disclosure. Accordingly, the drawings and description are to be regarded as illustrative in nature, and not as restrictive.

A more complete appreciation of the present disclosure and many of the attendant aspects thereof will be readily obtained as the same becomes better understood by reference to the following description when considered in connection with the accompanying drawings:
- FIG 1: is a flowchart representation of a method for measuring partial discharge (PD) in an electrical switchgear cabinet apparatus, in accordance with one or more embodiments of the present disclosure;
- FIG 2: is a block diagram representation of a sensor system for measuring partial discharge (PD) in an electrical switchgear cabinet apparatus, in accordance with one or more embodiments of the present disclosure;
- FIG 3: is an exemplary configuration depiction for a first mode of operation of the sensor system, in accordance with one or more embodiments of the present disclosure;
- FIG 4: is an exemplary configuration depiction for a second mode of operation of the sensor system, in accordance with one or more embodiments of the present disclosure;
- FIG 5: is an exemplary configuration depiction for a third mode of operation of the sensor system, in accordance with one or more embodiments of the present disclosure;
- FIG 6: is an exemplary configuration depiction for a fourth mode of operation of the sensor system, in accordance with one or more embodiments of the present disclosure;
- FIG 7: is an exemplary configuration depiction for a fifth mode of operation of the sensor system, in accordance with one or more embodiments of the present disclosure;
- FIG 8: is an exemplary configuration depiction for a sixth mode of operation of the sensor system, in accordance with one or more embodiments of the present disclosure;
- FIG 9: is an exemplary configuration depiction for a seventh mode of operation of the sensor system, in accordance with one or more embodiments of the present disclosure;
- FIG 10: is an exemplary configuration depiction for an eighth mode of operation of the sensor system, in accordance with one or more embodiments of the present disclosure;
- FIG 11: is an exemplary configuration depiction for a ninth mode of operation of the sensor system, in accordance with one or more embodiments of the present disclosure;
- FIG 12: is an exemplary configuration depiction for a tenth mode of operation of the sensor system, in accordance with one or more embodiments of the present disclosure;
- FIG 13: is a graph illustrating frequency response of the sensor system, in accordance with one or more embodiments of the present disclosure;
- FIG 14: is a graph illustrating simulated performance of the sensor system, in accordance with one or more embodiments of the present disclosure; and
- FIG 15A-15B: is a graph illustrating performance of the sensor system for specific current values, in accordance with one or more embodiments of the present disclosure.

Various embodiment-s are described with reference to the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

Examples of a method, a sensor system, and an electrical switchgear cabinet apparatus for measuring partial discharge (PD) are disclosed herein. In the following description, for the purposes of explanation, numerous specific details are set forth in order to provide a thorough understanding of the embodiments of the disclosure. It is apparent, however, to one skilled in the art that the embodiments of the disclosure may be practiced without these specific details or with an equivalent arrangement. In other instances, well-known structures and devices are shown in block diagram form in order to avoid unnecessarily obscuring the embodiments of the disclosure.

High-tension electrical switchgear cabinet apparatus is a huge cabinet which carries load directly to customer power supply. Therefore, an operating status of the electrical switchgear cabinet apparatus directly impacts customer power supply and reliability of the same. For the electrical switchgear cabinet apparatus needs to run for a very long duration of time and the same is inevitably. As a result, insulation degradation occurs due to aging, dampness, mechanical damage etc. Conventional methods and systems for measuring the partial discharge activity, the HFCTs and the IM units are being provided as a single solution for PD measurement by the vendor, when the IM unit is designed to be compatible for the HFCT provided. When a scenario arises of replacing either the HFCT or the IM unit, customer needs to use the same vendor's offering, restricting the use of different HFCTs.

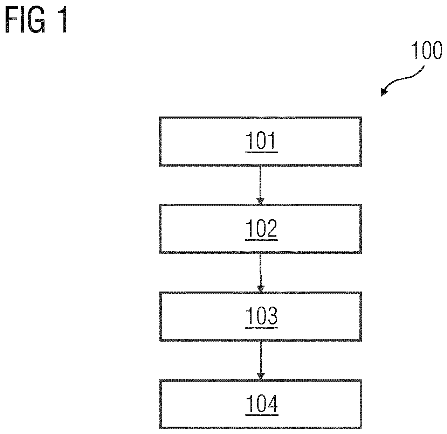

Referring now to FIG 1, illustrated is a flowchart of a method (as represented by reference numeral 100) for measuring partial discharge (PD) in an electrical switchgear cabinet apparatus, in accordance with an embodiment of the present disclosure. As used herein, the Partial Discharge (PD) is a phenomenon that occurs in an insulation system due to insulation deterioration caused by factors such as ageing, improper installation, manufacturing defects, or any other physical damage wherein, few milliamperes of high frequency pulsating current discharges are emitted from the deteriorated area when the applied voltage is more than the breakdown voltage of the damaged/deteriorated insulation. Generally, sensors providing fixed type of output are used to measure the PD resulting in compatibility issues with the IM units to which it may be connected to for providing the results. Also, since there is a possibility of the magnetic interference corrupting the PD measurement signal when there is no

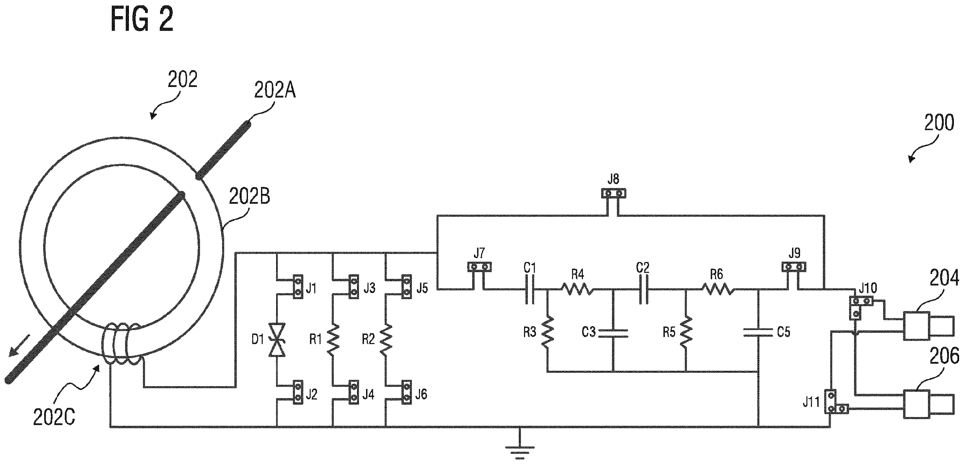

Referring to FIGS 1 and 2 in combination, the various steps of the method 100 as described hereinafter may be executed in the sensor system 200, for - measuring the partial discharge (PD) in an electrical switchgear cabinet apparatus 1000. For purposes of the present disclosure, the measuring of the PD in the electrical switchgear cabinet apparatus 1000 is well known in art. However, there are a number of factors which impact the measurement of the PD. It may be appreciated that although the method 100 is illustrated and described as a sequence of steps, it may be contemplated that various embodiments of the method 100 may be performed in any order or a combination and need not include all of the illustrated steps.

In embodiments of the present disclosure, at step 101, the method 100 includes mounting the sensor system 200 within the . The sensor system 200 is mounted inside the electrical switchgear cabinet apparatus 1000 so that the PD can be monitored. The sensor system 200 is sensitive to transient voltages in the sensor system 200, which will arise from partial discharge events occurring in the electrical switchgear cabinet apparatus 1000.

In embodiments of the present disclosure, at step 102, the method 100 includes determining a configurable output signal using the sensor system 200. The sensor system 200 includes a HCFT sensor 202 for measuring the partial discharge activity within the electrical switchgear cabinet apparatus 1000. The configurable output signal is the output of the sensor system 200 which needs to be measured to know the PD activity. The HCFT sensor 202 of the sensor system 200 includes the reconfigurable electronic circuit is used to provide a configurable output which may be either current or voltage. Therefore, unlike the conventional methods and systems the proposed sensor system 200 does not require a separate device or medium to configure the output to make the output compatible to IM units.

In embodiments of the present disclosure, at step 103, the method 100 includes monitoring the partial discharge activity based on configurable output signal. The configurable output signal is one of: a current signal and a voltage signal. The partial discharge activity is monitored over a period of time to know the status of the same.

In embodiments of the present disclosure, at step 104, the method 100 includes displaying information associated with the partial discharge activity based on the monitoring. The partial discharge activity or the performance of the sensor system 200 may be displayed on a display to be made available to a user. Further, the PD activity data may be stored for further analysis or usage.

FIG 2 is a block diagram representation of a sensor system 200 for measuring partial discharge (PD) in an electrical switchgear cabinet apparatus 1000, in accordance with one or more embodiments of the present disclosure. Referring to the FIG. 2, the sensor system 200 includes a High Frequency Current Transformer (HFCT) sensor 202 for measuring a High Frequency Current (HFC) signal. The HFC signal indicates the partial discharge activity in the electrical switchgear cabinet apparatus 1000. The HFCT sensor 202 includes a primary coil 202A, a secondary coil 202B, and a core 202C of high relative permeability. The HCFT sensor 202 includes toroidal core 202C material (usually with high permeability such as ferrite) and insulated copper wire wound on the core 202C with a load impedance connected between its terminals forming the coils. The primary coil 202A, the secondary coil 202B, and the core 202C are shielded with an aluminium casing which eliminates any form of environmental interferences. The shield also covers an inner circle of the core 202C which is toroidal, providing good shielding from noise interferences.

The sensor system 200 also includes a reconfigurable electronic circuit connected to the HFCT sensor 202 for transforming the HFC signal indicating partial discharge activity into a form that is compatible with the IM unit. For example, the IM unit may require the signal in form of current signal then the reconfigurable electronic circuit provides the final signal in the form of current signal. The transformation is done using multiple modes of operation of the sensor system 200. This reconfigurable electronic circuit includes multiple switches (J1, J2, J3, J4, J5, J6, J7, J8, J9, J10 and J11), a transient voltage protection diode (D1), multiple termination resistance (R1 and R2) and a passive bandpass filter. The switches may also be jumpers. The transient voltage protection diode D1 is connected in parallel to the secondary coil 202B of the HFCT sensor 202 and the transient voltage protection diode D1 is operated using the J1 and the J2. The passive bandpass filter is configured to allow a specific frequency range of the HFCT signal during the transformation and filter is operated using the J7, the J8 and the J9. The bandpass filtering may be done in a frequency range of 3 MHz to 30 MHz. The termination resistance used throughout the description are R1 is 50Ω and R2 is 1MΩ. However, these are mere examples and do not restrict the scope of the disclosure.

The sensor system 200 includes output ports connected to the reconfigurable electronic circuit and the output ports are configured to provide the configurable output signal to an instrumentation and measurement (IM) unit in a form that is compatible to the same. The configurable output signal is either a current signal or a voltage signal. The output port has an output connector type which may be either a SMA type 204 and a BNC type 206. Further, the instrumentation and measurement (IM) unit connected to the output ports of the sensor system 200 is configured to receive the configurable output signal through a compatible output connector type and display information associated with the partial discharge activity.

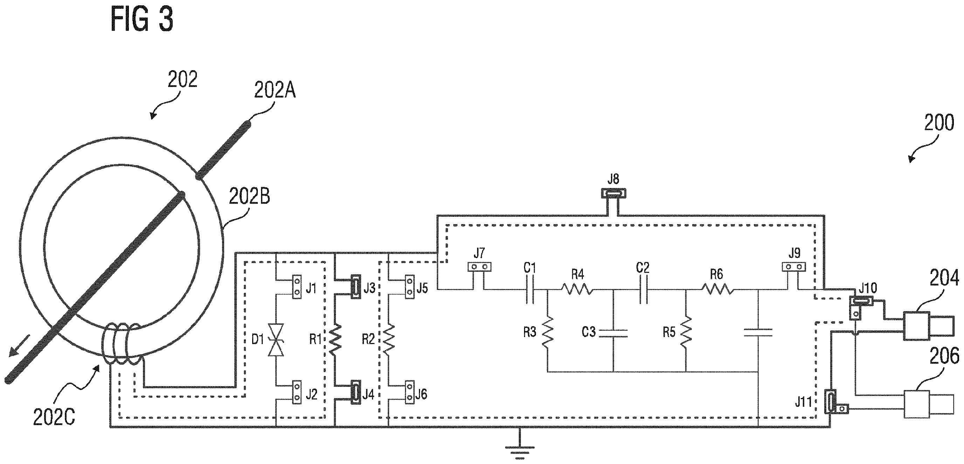

For the operation of the sensor system 200 is performed by connecting the earth line of the electrical switchgear cabinet apparatus 1000 generally in a LV compartment. The sensor system 200 is configured to measure the partial discharge signal, filter the signal, and made available to the IM unit with required output type (either voltage or current) through compatible connection type. The multiple modes of operation of the sensor system 200 include ten modes. The ten modes are as follows and are explained in detail from FIG.3- FIG.12:
a. a first mode of operation includes a first termination resistance R1, the configurable output signal is the voltage signal, and the output connector type is SMA 204;
b. a second mode of operation includes the first termination resistance R1, the configurable output signal is the voltage signal, and the output connector type is BNC 206;
c. a third mode of operation includes a first termination resistance R2, the configurable output signal is the voltage signal, and the output connector type is SMA 204;
d. a fourth mode of operation includes the first termination resistance R2, the configurable output signal is the voltage signal, and the output connector type is BNC 206;
e. a fifth mode of operation includes transient voltage protection, the first termination resistance R1, the configurable output signal is the voltage signal with bandpass filtering and the output connector type is SMA 204;
f. a sixth mode of operation includes transient voltage protection, the first termination resistance R1, the configurable output signal is the voltage signal with bandpass filtering and the output connector type is BNC 206;
g. a seventh mode of operation includes transient voltage protection, the first termination resistance R2, the configurable output signal is the voltage signal with bandpass filtering and the output connector type is SMA 204;
h. an eighth mode of operation includes transient voltage protection, the first termination resistance R2, the configurable output signal is the voltage signal with bandpass filtering and the output connector type is BNC 206;
i. a ninth mode of operation includes no termination resistance, the configurable output signal is the current signal, and the output connector type is SMA 204; and
j. a tenth mode of operation includes no termination resistance, the configurable output signal is the current signal, and the output connector type is BNC 206.

FIG 3 is an exemplary configuration depiction for a first mode of operation of the sensor system 200, in accordance with one or more embodiments of the present disclosure. Referring to the FIG. 3, the operation of the sensor system 200 in the first mode of operation is provided. The first mode of operation includes the first termination resistance R1, the configurable output signal is the voltage signal, and the output connector type is SMA 204. In the first mode of operation, the sensor system 200 is configured to have a termination resistance R1 of 50 Q and the output voltage is obtained through the SMA output 204. The switches J3, J4 and J8 are shorted, and the rest of the switches are made open so that required featuares are enabled. J10 and J11 are configured to connect the SMA output 204 and bypass the BNC output 206.

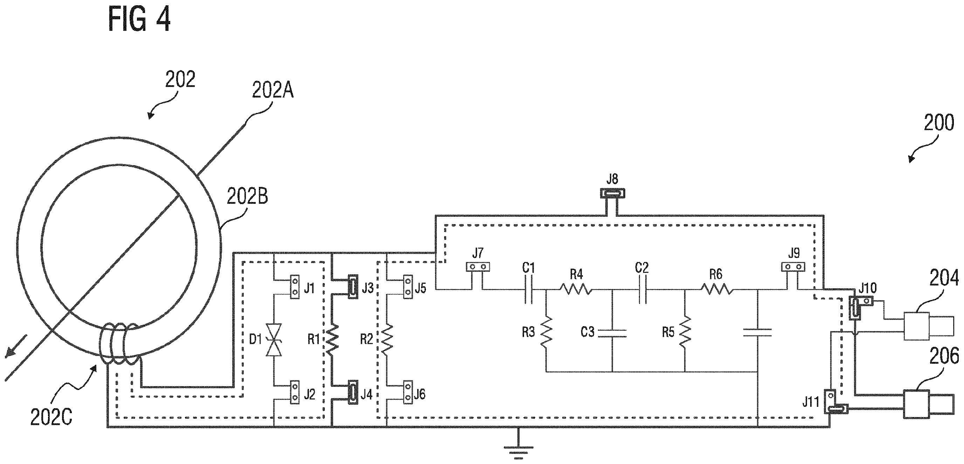

FIG 4 is an exemplary configuration depiction for a second mode of operation of the sensor system 200, in accordance with one or more embodiments of the present disclosure. Similar to, the first mode of operation, the second mode of operation follows the same configuration however the output is configured to be taken from the BNC connection 206 and bypass the SMA connection 204. Referring to the FIG. 4, the operation of the sensor system 200 in the second mode of operation is provided. The second mode of operation includes the first termination resistance R1, the configurable output signal is the voltage signal, and the output connector type is BNC 206. In the second mode of operation, the sensor system 200 is configured to have a termination resistance R1 of 50 Ω and the output voltage is obtained through the BNC output 206. The switches J3, J4 and J8 are shorted, and the rest of the switches are made open so that required features are enabled. J10 and J11 are configured to connect the BNC output 206 and bypass the SMA output 204.

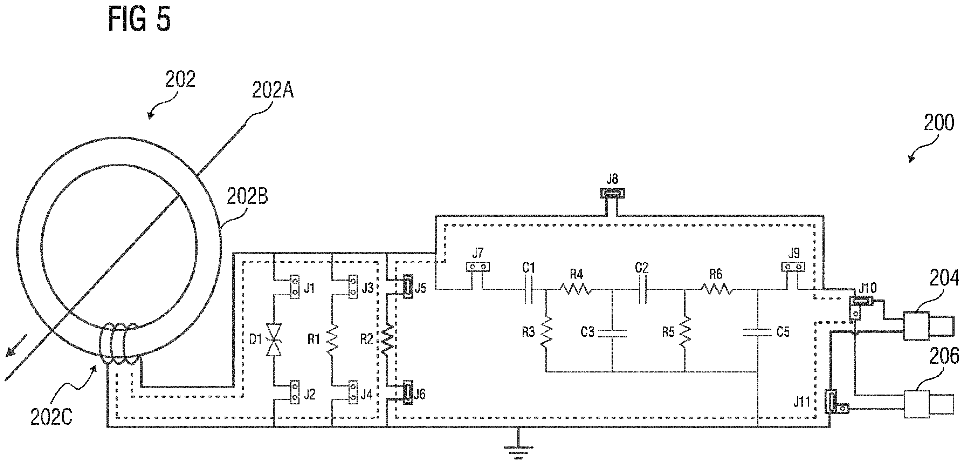

FIG 5 is an exemplary configuration depiction for a third mode of operation of the sensor system, in accordance with one or more embodiments of the present disclosure. Referring to the FIG. 5, the operation of the sensor system 200 in the third mode of operation is provided. The third mode of operation includes the second termination resistance R2, the configurable output signal is the voltage signal, and the output connector type is SMA 204. In the third mode of operation, the sensor system 200 is configured to have a termination resistance R2 of 1 MΩ and the output voltage is obtained through the SMA output 204. The switches J5, J6 and J8 are shorted, and the rest of the switches are made open so that required features are enabled. J10 and J11 are configured to connect the SMA output 204 and bypass the BNC output 206.

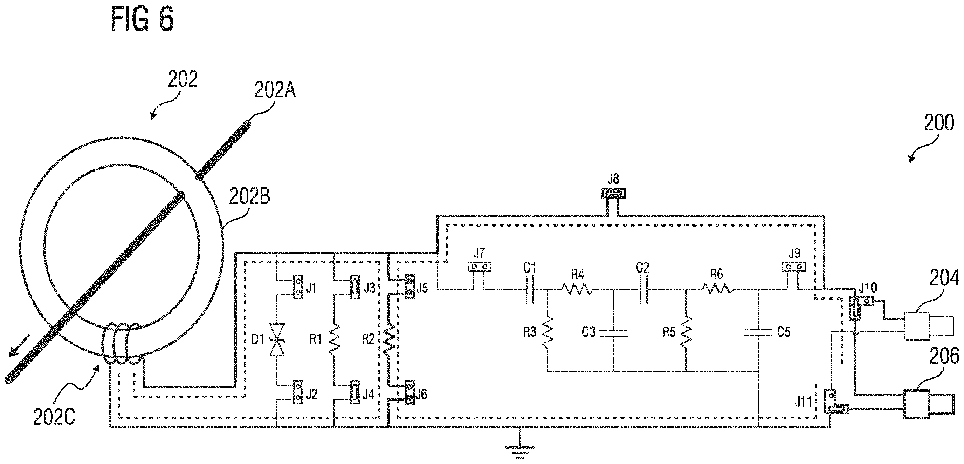

FIG 6 is an exemplary configuration depiction for a fourth mode of operation of the sensor system 200, in accordance with one or more embodiments of the present disclosure. Similar to, the third mode of operation, the fourth mode of operation follows the same configuration however the output is configured to be taken from the BNC connection 206 and bypass the SMA connection 204. Referring to the FIG. 4, the operation of the sensor system 200 in the fourth mode of operation is provided. The fourth mode of operation includes the second termination resistance R2, the configurable output signal is the voltage signal, and the output connector type is BNC 206. In the fourth mode of operation, the sensor system 200 is configured to have a termination resistance R2 of 1 MΩ and the output voltage is obtained through the BNC output 206. The switches J5, J6 and J8 are shorted, and the rest of the switches are made open so that required features are enabled. J10 and J11 are configured to connect the BNC output 206 and bypass the SMA output 204.

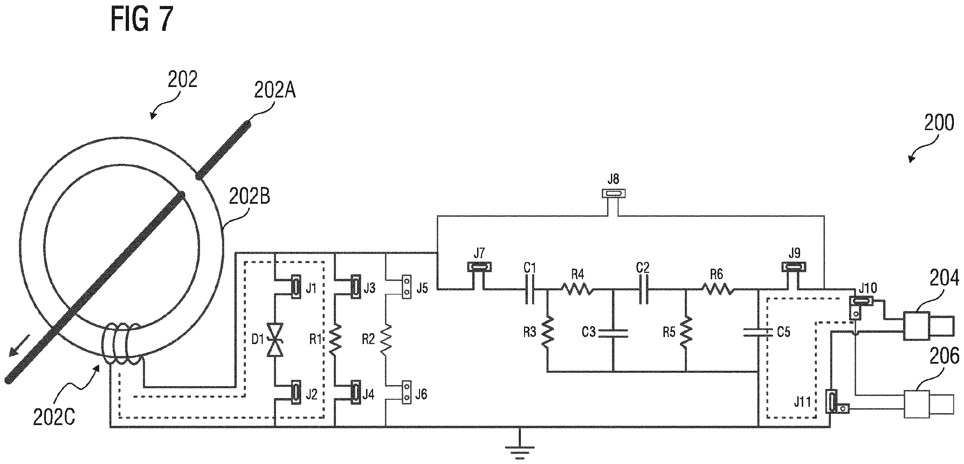

FIG 7 is an exemplary configuration depiction for a fifth mode of operation of the sensor system, in accordance with one or more embodiments of the present disclosure. Referring to the FIG. 7, the operation of the sensor system 200 in the fifth mode of operation is provided. The fifth mode of operation includes the first termination resistance R1, the configurable output signal is the voltage signal with bandpass filtering and the output connector type is SMA 204. In the fifth mode of operation, the sensor system 200 is configured to have a termination resistance R1 of 50 Ω, possess a transient voltage protection circuit, filter the input output voltage signal and the output voltage is obtained through the SMA output 204. The switches J1, J2, J3, J4, J7 and J9 are shorted, and the rest of the switches are made open so that required features are enabled. J10 and J11 are configured to connect the SMA output 204 and bypass the BNC output 206.

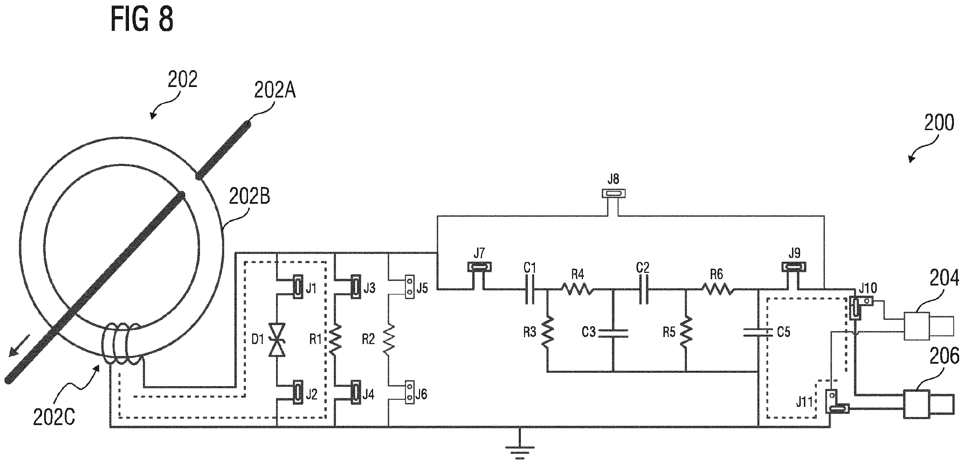

FIG 8 is an exemplary configuration depiction for a sixth mode of operation of the sensor system, in accordance with one or more embodiments of the present disclosure. Similar to, the fifth mode of operation, the sixth mode of operation follows the same configuration, however, the output is configured to be taken from BNC connection 206 and bypass the SMA connection 204. Referring to the FIG. 38, the operation of the sensor system 200 in the sixth mode of operation is provided. The sixth mode of operation includes the first termination resistance R1, the configurable output signal is the voltage signal with bandpass filtering and the output connector type is BNC 206. In the sixth mode of operation, the sensor system 200 is configured to have a termination resistance R1 of 50 Ω, possess a transient voltage protection circuit, filter the input output voltage signal and the output voltage is obtained through the BNC output 206. The switches J1, J2, J3, J4, J7 and J9 are shorted, and the rest of the switches are made open so that required features are enabled. J10 and J11 are configured to connect the SMA output 204 and bypass the BNC output 206.

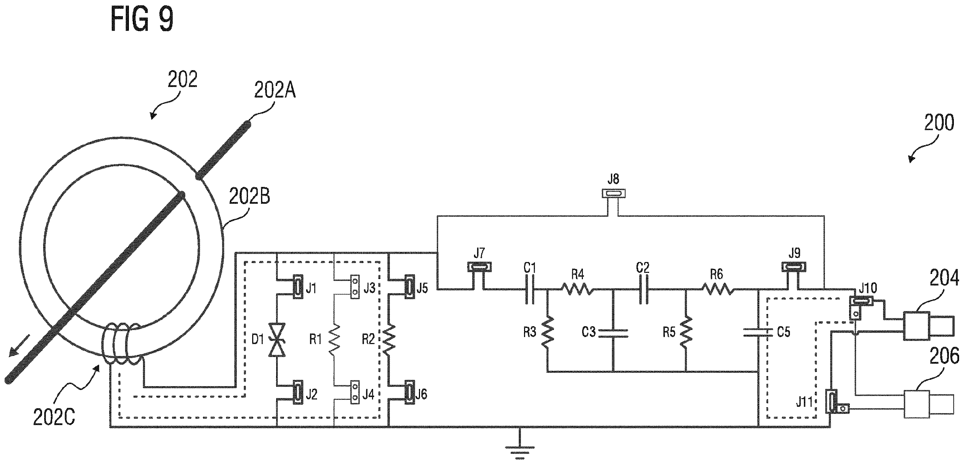

FIG 9 is an exemplary configuration depiction for a seventh mode of operation of the sensor system, in accordance with one or more embodiments of the present disclosure. Referring to the FIG. 9, the operation of the sensor system 200 in the seventh mode of operation is provided. The seventh mode of operation includes the second termination resistance R2, the configurable output signal is the voltage signal with bandpass filtering and the output connector type is SMA 204. In the seventh mode of operation, the sensor system 200 is configured to have a termination resistance R2 of 1M Ω, possess a transient voltage protection circuit, filter the input output voltage signal and the output voltage is obtained through the SMA output 204. The switches J1, J2, J5, J6, J7 and J9 are shorted, and the rest of the switches are made open so that required features are enabled. J10 and J11 are configured to connect the SMA output 204 and bypass the BNC output 206.

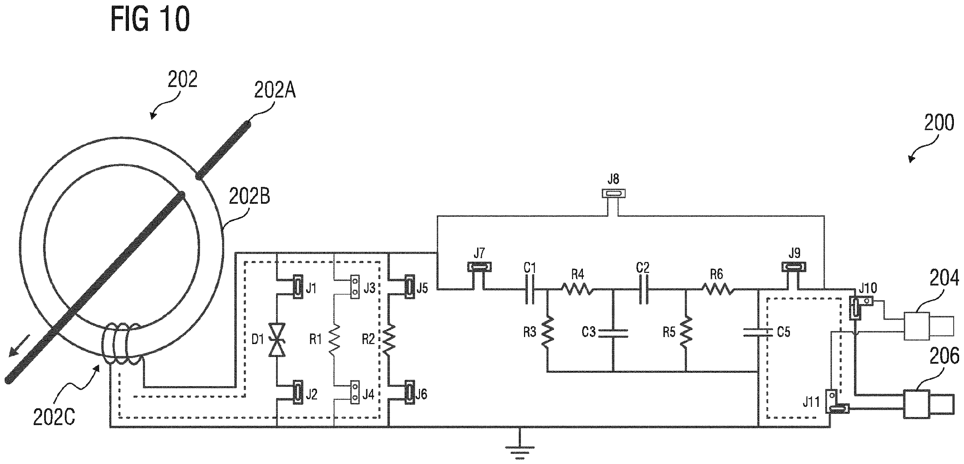

FIG 10 is an exemplary configuration depiction for an eighth mode of operation of the sensor system, in accordance with one or more embodiments of the present disclosure. Similar to, the seventh mode of operation, the eighth mode of operation follows the same configuration, however, the output is configured to be taken from BNC connection 206 and bypass the SMA connection 204. Referring to the FIG. 10, the operation of the sensor system 200 in the eighth mode of operation is provided. The eighth mode of operation includes the second termination resistance R2, the configurable output signal is the voltage signal with bandpass filtering and the output connector type is the BNC 206. In the eighth mode of operation, the sensor system 200 is configured to have a termination resistance R2 of 1M Ω, possess a transient voltage protection circuit, filter the input output voltage signal and the output voltage is obtained through the BNC 206. The switches J1, J2, J5, J6, J7 and J9 are shorted, and the rest of the switches are made open so that required features are enabled. J10 and J11 are configured to connect the BNC output 206 and bypass the SMA output 204.

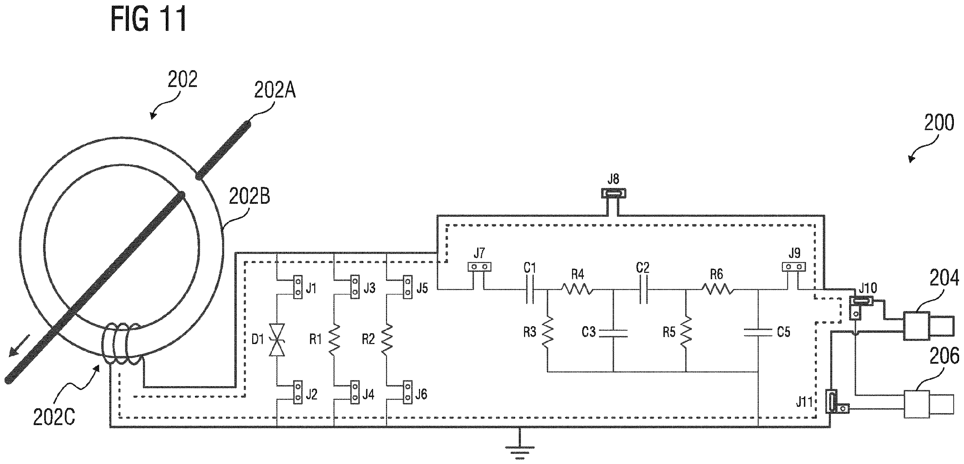

FIG 11 is an exemplary configuration depiction for a ninth mode of operation of the sensor system, in accordance with one or more embodiments of the present disclosure. Referring to the FIG. 11, the operation of the sensor system 200 in the ninth mode of operation is provided. The ninth mode of operation does not include any second termination resistance, the configurable output signal is the current signal, and the output connector type is SMA 204. In the ninth mode of operation, the sensor system 200 is configured to give current as an output and hence no termination resistance is added in the secondary loop. The switch J8 is shorted, and all the remaining switches are kept open so that the terminal voltage protection, termination, and filtering circuit are bypassed. J10 and J11 are configured to connect the SMA output 204 and bypass BNC connector 206. Therefore, the proposed sensor system 200 is configured to provide both voltage and current outputs, making it compatible with both kind of output IM units.

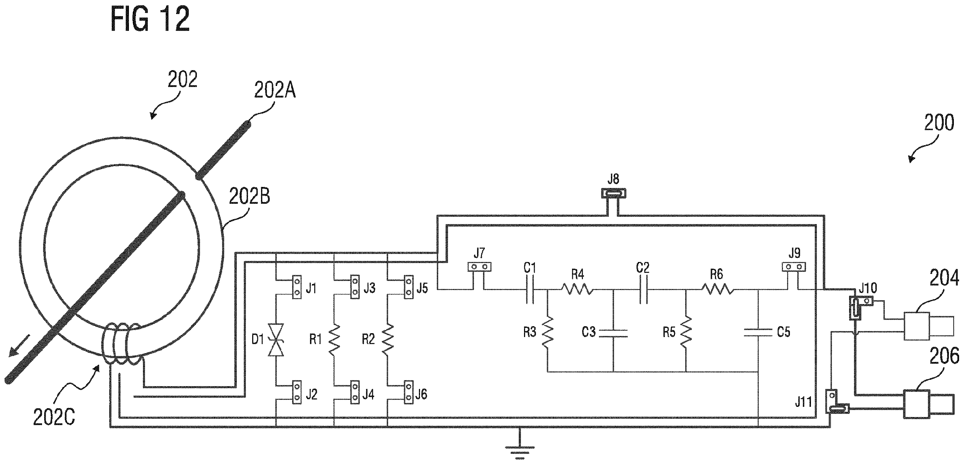

FIG 12 is an exemplary configuration depiction for a tenth mode of operation of the sensor system 200, in accordance with one or more embodiments of the present disclosure. Referring to the FIG. 12, the operation of the sensor system 200 in the tenth mode of operation is provided. The tenth mode of operation does not include any second termination resistance, the configurable output signal is the current signal, and the output connector type is BNC 206. In the tenth mode of operation, the sensor system 200 is configured to give current as an output and hence no termination resistance is added in the secondary loop. The switch J8 is shorted, and all the remaining switches are kept open so that the terminal voltage protection, termination, and filtering circuit are bypassed. J10 and J11 are configured to connect the BNC connector 206 and bypass SMA output 204.

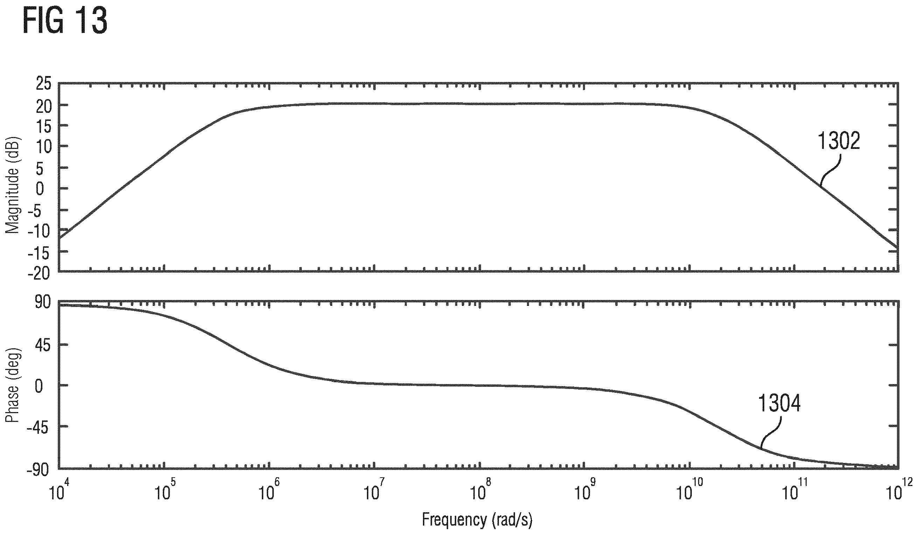

FIG 13 is a graph illustrating frequency response of the sensor system, in accordance with one or more embodiments of the present disclosure. A model of the sensor system 200 is developed in MATLAB simulation platform, analysed for its working, and simulated for its performance under different test conditions and loading. The example model parameters considered are N1 = 1, N2 = 2, gain = 25 mV/mA and saturation frequency = 70 MHz. FIG. 13 provides the frequency response of the sensor system 200 with gain 1302 and phase angle variation 1304 under different operating frequency range.

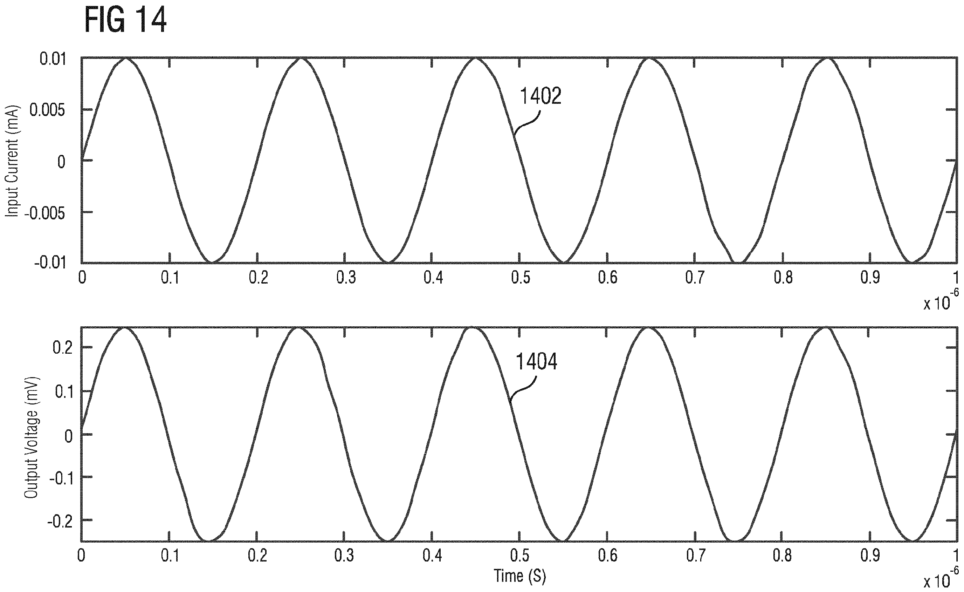

FIG 14 is a graph illustrating simulated performance of the sensor system 200, in accordance with one or more embodiments of the present disclosure. The FIG. 14 indicates the simulated performance of the sensor system 200 for a 10 mA, 5 MHz current signal. The 1402 is the input current signal and the 1404 is the output current signal which are in-phase indicating the high efficiency of the sensor system 200.

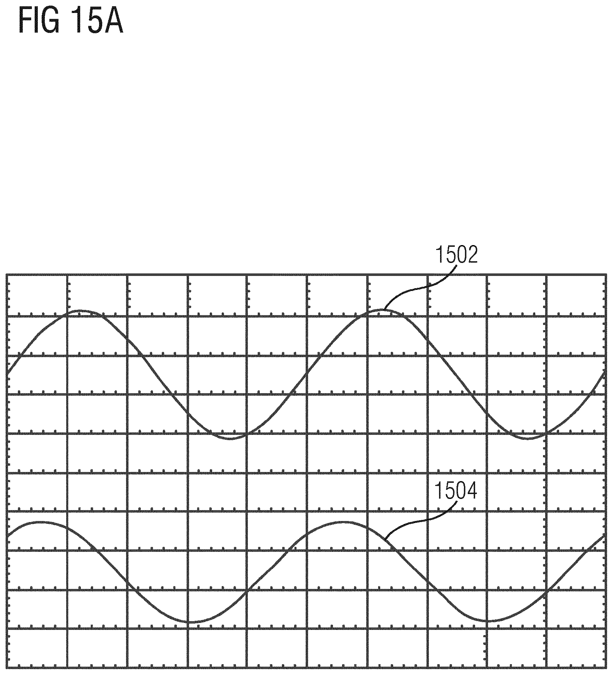

FIG 15A-15B is a graph illustrating performance of the sensor system 200 for specific current values, in accordance with one or more embodiments of the present disclosure. A prototype of the sensor system 200 including the reconfigurable HFCT is validated in a lab setup. The performance is noted with the results of the HFCT output for the different input high frequency current signals (Sine).

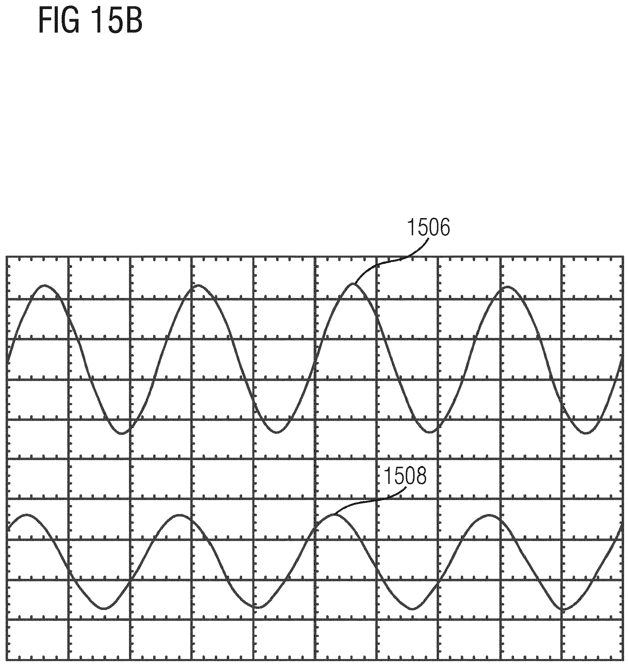

Referring to the FIG. 15A, the performance of sensor system 200 for 5 MHz 20mA current signal with output 1502 and the input 1504. Similarly, the FIG. 15B, the performance of sensor system 200 for 10 MHz 20mA current signal with output 1506 and the input 1508 is indicated.

While the present disclosure has been described in detail with reference to certain embodiments, it should be appreciated that the present disclosure is not limited to those embodiments. In view of the present disclosure, many modifications and variations would be present themselves, to those skilled in the art without departing from the scope of the various embodiments of the present disclosure, as described herein. The scope of the present disclosure is, therefore, indicated by the following claims rather than by the foregoing description. All changes, modifications, and variations coming within the meaning and range of equivalency of the claims are to be considered within their scope.

### Bezugszeichenliste

| | |
|---|---|
| method | 100 |
| step | 101 |
| step | 102 |
| step | 103 |
| step | 104 |
| sensor system | 200 |
| HFCT sensor | 202 |
| primary coil | 202A |
| secondary coil | 202B |
| core | 202C |
| SMA | 204 |
| BNC type | 206 |
| switches | J1, J2, J3, J4, J5, J6, J7, J8, J9, J10 and J11 |
| termination resistance | R1 and R2 |
| transient voltage protection diode | D1 |
| Graph input and output | 1302, 1304, 1402,1404, 1502, 1504, 1506, 1508 |

## Claims

1. A sensor system (200) for measuring partial discharge (PD) in an electrical switchgear cabinet apparatus (1000), wherein the sensor system (200) comprises:
a High Frequency Current Transformer (HFCT) sensor (202) configured to measure a High Frequency Current (HFC) signal, wherein the HFC signal indicates the partial discharge activity in the electrical switchgear cabinet apparatus (1000);
a reconfigurable electronic circuit connected to the HFCT sensor (202) and configured to transform the measured HFC signal indicating the partial discharge activity to a configurable output signal, wherein the reconfigurable electronic circuit comprises a plurality of switches (J1, J2, J3, J4, J5, J6, J7, J8, J9, J10 and J11), a transient voltage protection diode (D1), a plurality of termination resistance (R1 and R2) and a passive bandpass filter and wherein the HFC signal is transformed using a plurality of modes of operation of the reconfigurable electronic circuit; and
output ports connected to the reconfigurable electronic circuit and configured to provide the configurable output signal to an instrumentation and measurement (IM) unit, wherein the configurable output signal is one of: a current signal and a voltage signal and wherein a magnitude of the configurable output signal is provided to the instrumentation and measurement (IM) unit.

2. The sensor system (200) as claimed in claim 1, wherein the output ports is an output connector type comprising one of a SMA (204) type and a BNC type (206).

3. The sensor system (200) as claimed in claim 1, wherein the plurality of modes of operation comprises one of:
a. a first mode of operation comprising a first termination resistance (R1), the configurable output signal is the voltage signal, and the output connector type is SMA (204) ;
b. a second mode of operation comprising the first termination resistance (R1), the configurable output signal is the voltage signal, and the output connector type is BNC (206);
c. a third mode of operation comprising a first termination resistance (R2), the configurable output signal is the voltage signal, and the output connector type is SMA (204) ;
d. a fourth mode of operation comprising the first termination resistance (R2), the configurable output signal is the voltage signal, and the output connector type is BNC (206);
e. a fifth mode of operation comprising transient voltage protection, the first termination resistance (R1), the configurable output signal is the voltage signal with bandpass filtering and the output connector type is SMA (204) ;
f. a sixth mode of operation comprising transient voltage protection, the first termination resistance (R1), the configurable output signal is the voltage signal with bandpass filtering and the output connector type is BNC (206) ;
g. a seventh mode of operation comprising transient voltage protection, the first termination resistance (R2), the configurable output signal is the voltage signal with bandpass filtering and the output connector type is SMA (204) ;
h. an eighth mode of operation comprising transient voltage protection, the first termination resistance (R2), the configurable output signal is the voltage signal with bandpass filtering and the output connector type is BNC (206) ;
i. a ninth mode of operation comprising no termination resistance, the configurable output signal is the current signal, and the output connector type is SMA (204); and
j. a tenth mode of operation comprising no termination resistance, the configurable output signal is the current signal, and the output connector type is BNC (206) .

4. The sensor system (200) as claimed in claim 1, wherein the passive bandpass filter is configured to allow a specific frequency range of the HFCT signal for monitoring the PD and wherein the passive bandpass filter is operable using the switches (J7, J8 and J9).

5. The sensor system (200) as claimed in claim 1, wherein the HFCT sensor (202) comprises a primary coil (202A), a secondary coil (202B), and a core (202C) of high relative permeability.

6. The sensor system (200) as claimed in claim 5, wherein the primary coil (202A), the secondary coil (202B), and the core (202C) is shielded with aluminium casing to eliminate environmental interferences and noise interferences to the HFCT signal.

7. The sensor system (200) as claimed in claim 1, wherein the transient voltage protection diode D1 is connected in parallel to the secondary coil (202B) of the HFCT sensor (202) and the transient voltage protection diode (D1) is operable using the J1 and the J2.

8. The sensor system (200) as claimed in claim 1, wherein the plurality of termination resistance termination resistance is operated using a combination of: the J3 and the J4, or the J5 and the J6.

9. The sensor system (200) as claimed in claim 1, further comprising:
an instrumentation and measurement (IM) unit connected to the output ports of the sensor system (200) and configured to: receive the configurable output signal through a compatible output connector type and display information associated with the partial discharge activity.

10. An electrical switchgear cabinet apparatus (1000) for measuring partial discharge (PD), wherein the electrical switchgear cabinet apparatus 1000comprising:
the electrical switchgear cabinet comprising a sensor system (200) for measuring the PD, the sensor system (200) comprises:
a High Frequency Current Transformer (HFCT) sensor (202) configured to measure a High Frequency Current (HFC) signal, wherein the HFC signal indicates the partial discharge activity in the electrical switchgear cabinet apparatus (1000);
a reconfigurable electronic circuit connected to the HFCT sensor (202) and configured to transform the measured HFC signal indicating the partial discharge activity to a configurable output signal, wherein the reconfigurable electronic circuit comprises a plurality of switches (J1, J2, J3, J4, J5, J6, J7, J8, J9, J10 and J11), a transient voltage protection diode (D1), a plurality of termination resistance (R1 and R2) and a passive bandpass filter and wherein the HFC signal is transformed using a plurality of modes of operation of the reconfigurable electronic circuit; and
output ports connected to the reconfigurable electronic circuit and configured to provide the configurable output signal to an instrumentation and measurement (IM) unit, wherein the configurable output signal is one of: a current signal and a voltage signal and wherein a magnitude of the configurable output signal is provided to the instrumentation and measurement (IM) unit.

11. A method (100) for measuring partial discharge (PD) in an electrical switchgear cabinet apparatus (1000), the method comprising:
mounting a sensor system (200) within the electrical switchgear cabinet apparatus (1000);
determining a configurable output signal using the sensor system (200), wherein the sensor system (200) comprises a HCFT sensor (202) for measuring of a partial discharge activity;
monitoring the partial discharge activity based on configurable output signal, wherein the configurable output signal is one of: a current signal and a voltage signal; and
displaying information associated with the partial discharge activity based on the monitoring.

12. A method (100) for measuring partial discharge (PD) in an electrical switchgear cabinet apparatus (1000), the method comprising:
measuring a High Frequency Current (HFC) signal, wherein the HFC signal indicates the partial discharge activity in the electrical switchgear cabinet apparatus (1000);
transforming the measured HFC signal indicating the partial discharge activity to a configurable output signal; and
providing the configurable output signal to an instrumentation and measurement (IM) unit, wherein the configurable output signal is provided as one of: a current signal and a voltage signal.
